Europäisches Patentamt

**European Patent Office**

**Office européen des brevets**

(11) Publication number: **0 207 772**
**A2**

# EUROPEAN PATENT APPLICATION

(21) Application number: 86305062.1

(22) Date of filing: 30.06.86

(51) Int. Cl.⁴: **H01J 1/16 , H01J 9/04**

(30) Priority: **02.07.85 GB 8516790**

(43) Date of publication of application:
**07.01.87 Bulletin 87/02**

(84) Designated Contracting States:
**CH DE FR LI NL**

(71) Applicant: **Brünger, Wilhelm Heinrich Dr.**
**Landhaushöhe 11-1**
**D-7400 Tubingen 6(DE)**
Applicant: **Nixon, William Charles Dr.**
**9, Causewayside**
**Cambridge(GB)**

(72) Inventor: **Brünger, Wilhelm Heinrich Dr.**
**Landhaushöhe 11-1**
**D-7400 Tubingen 6(DE)**
Inventor: **Nixon, William Charles Dr.**
**9, Causewayside**
**Cambridge(GB)**

(74) Representative: **Nash, Keith Wilfrid et al**
**KEITH W. NASH & Co. Pearl Assurance**
**House 90-92 Regent Street**
**Cambridge CB2 1DP(GB)**

(54) Electron source of lanthanum hexaboride and method of constructing same.

(57) An electron emitter comprises a single, cubic lanthanum hexaboride crystal (1) mounted in a supporting material heatable by heating wires (3), the arrangement being such that a naturally grown edge (2) between two crystal faces, preferably (1,0,0) faces, forms a line emitter which has high length to radius and width ratios, preferably of at least 50 : 1.

Fig.1

EP 0 207 772 A2

## Electron Source of Lanthanum Hexaboride and method of constructing same.

### Field of the invention

The present invention relates to the use of lanthanum hexaboride (LaB6) as an electron emitter. Such a source finds application in many microelectronic engineering applications.

### Background to the invention

Known lanthanum hexaboride emitters are formed of sintered powder material or single crystals mechanically or chemically shaped into a cone or pyramid or sometimes into a truncated cone or rod. The aim hitherto has always been to provide a small emitting area from which electrons emerge with rotational symmetry.

Lanthanum hexaboride material is chosen because it has a lower work function and will emit electrons at a lower temperature than tungsten, for example. This means that because of the low work function more intensive electron sources with smaller emission surfaces and longer lifetimes are possible.

It is known to grow cubes of lanthanum hexaboride in a natural crystallographic manner. (T. Aita, U. Kawabe and Y. Honda, "Single Crystal Growth of Lanthanum Hexaboride in Molten Aluminium", Appl. Physics Vol. 13, No. 2, p.391, 1974). In this process, growth, crystal form and size are determined by selection of the ratio of lanthanum to boron and by the pressures and temperatures used. Using this method, LaB6 single crystals can be produced in large quantities.

During the development of the present invention, cube shaped LaB6 crystals have been mounted in such an orientation that a corner of the cube formed by three cube faces forms a point electron source.

In many new applications however, some of which will be referred to later, line electron sources are needed. Such sources are already used to a limited extent, for example in various X-ray tubes where a heated wire is used as the electron source.

Line sources of this kind, in limited usage hitherto, can be constructed with a ratio of length to width of the emitting line of at best 10 : 1; for example a wire of 100 um cross-sectional diameter along 1 mm length. Longer wires cannot be mounted in a manner which remains stable at the high operating temperatures necessary in use.

For many modern applications of electron emitters an increased length to linewidth ratio would be desirable. Line sources with such higher ratios of length to width would make possible many new applications in electron beam technology.

### Prior Art

US Patent 4482838 Ishii et al describes a process for obtaining a thermionic emission cathode of a single crystal in which one end of the crystal is machined to form the electron emitter. Damage caused by the machining process disrupts the crystalline structure in the region of the machined surfaces and the US Patent describes how this damage can be removed, so as to expose what are described in the patent as natural crystal faces, either by vacuum heat treatment (similar to the evaporation which occurs during initial stages of the life of an emitter in scanning electron microscopes and the like) or by a much faster process of chemical etching.

However there is nothing in the US Patent which would lead one to employ anything other than a fabricated (ie machined) crystal as the emitter, which is quite distinct from the present invention.

Additionally although the US Patent is directed to the production of single point source types of emitter, (viz. the formation of a generally pointed end surrounded by faces of a polyhedron at one end of a column of crystal), Figs 4a and 4b of the US Patent show a crystal having a hipped roof form, with the ridge of the "roof" forming the "pointed" end. However it will be seen from a study of the US Patent that the ridge of the "roof" will not serve as a line source since the ends of the ridge merge into the triangular regions of the hipped roof configuration and there are no well-defined ends to the ridge. Furthermore the length of the ridge will be of the order of a few microns given that the typical diameter of the crystal column is of the order of 1mm in the first place. As such the ridge will not act as a line source but as an inferior point source.

### Object of the invention

It is an object of the present invention to provide a line source, for example having a line length of 1mm whilst maintaining sufficiently high emission densities at the same time.

It is another object of the invention to provide a method of making such sources.

### The invention

The problem is solved by an electron emitter comprising a lanthanum hexaboride (LaB6) single crystal mounted on to a heatable support in such a manner that one of the grown crystal edges forms

ectron emitting line source and plane ends of ystal substantially perpendicular to the direc- the edge, define the opposite ends of the

The invention makes it possible not only to ...te a higher ratio of length to width but also for first time to construct electron line sources aller in width than visible light wavelengths. Furmore this can be achieved over a length of ny millimetres. Thus, ratios of length to width of 1, 500:1 and even 1000:1 become feasible.

n practice, many applications can be visualisfor line sources which are easier to handle, e cost effective and more precise in their di-nsions, and which in addition give improved nal/noise ratios. The signal/noise ratios are in-ased for many applications by the same factor which the ratio of length to width of the source reases.

In addition since the emission of LaB6 is much gher, for example, than tungsten, such a line urce in accordance with the invention is of suffi-ent intensity to open up new applications of us-je, with all the resultant advantages.

In known manner the total emission of a line urce formed by the edge of a LaB6 single crystal n be influenced by an electric field established a negative voltage applied to a control electrode sembly located between the line source and an celerating electrode assembly. The negative volt-e is adjustable in known manner to suit each ecific application.

It is advantageous to mount the LaB6 crystal o the heatable holder with two grown (1,0,0) es forming the edge. This gives stable emission nt from the beginning of use. The side emission the two (1,0,0) faces may be controlled by ropriately shaped electrodes, whilst the high ilable electron emission current may easily be creased if the resulting width of the energy dis-bution is not acceptable. As the edge of the itter of this invention is atomically sharp, the ergy distribution of the emitted electrons may in actice be made extremely small, for example as as 0.4 eV, which is of decisive importance for ny applications.

Because the edge is defined as the junction of crystal faces, it remains sharp despite removal material from the two faces during use.

Although (1,0,0) orientation has been referred nerein as a preferred crystal type, any other entation may be used (eg 1,1,0; 1,1,1; 2,1,0; provided it has a suitable edge to serve as the tron emitter.

According to another aspect of the invention a nod of constructing a line source electron emit-comprises the steps of mounting a single cry-on a heatable mount so that one of the naturally occurring edges of the crystal formed during growth of the crystal constitutes a ridge from which electrons can be emitted, the ridge being bounded on opposite sides by two naturally grown faces of the crystal and with the ends of the ridge being defined by plane ends of the crystal which are substantially perpendicular to the direction of the ridge.

Description of drawings

In the following the invention is exemplified with reference to the accompanying drawings, in which:

Figure 1 shows the mounting of a cube of LaB6 crystal to a single heating wire by means of a supportive material.

Figure 2 shows a similar, mechanically more stable configuration with two heating wires.

Figure 3 shows the mounting of the emitting crystal by clamping between two blocks.

Description of embodiments

The drawings show different mounting possibilities of a cubic LaB6 crystal with one grown edge of the crystal as the line source. In the first two examples, the cube of LaB6 crystal 1 is mounted in supporting material 4, and reference 2 denotes the line edge forming the emitter while reference 3 denotes a single or double heating wire. The emitting edge 2 emerges from the supporting material 4, which can consist of sintered titanium carbide, and which partially covers the cube 1 whilst leaving the emitting edge 2 exposed.

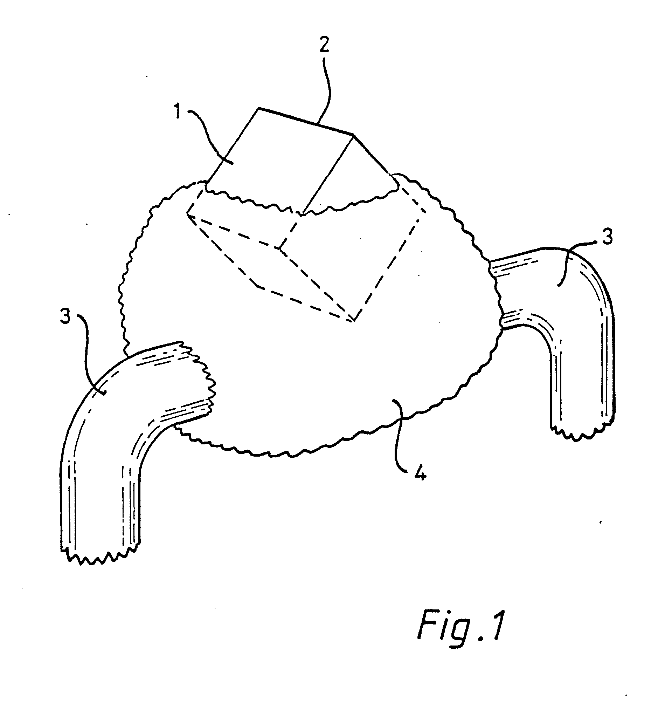

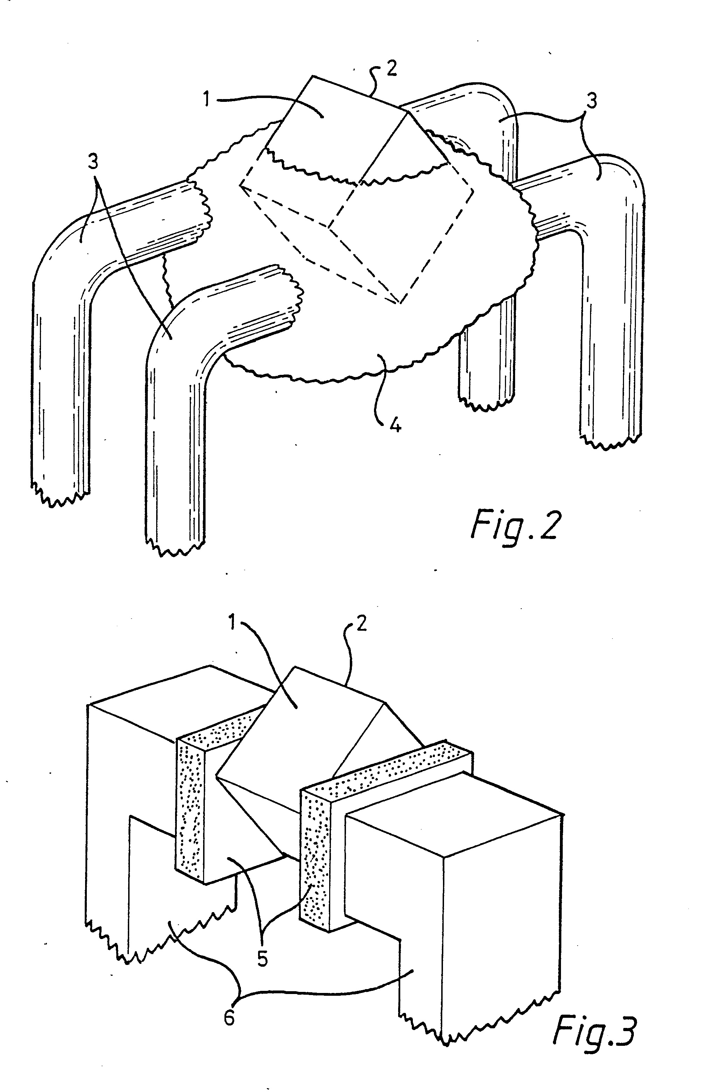

In contrary to Figure 1 and Figure 2, the emitting edge could also be mounted not vertical but parallel to the heating wire.

In the configuration according to Figure 3 the cubic crystal 1, with the same orientation of the emitting edge 2 as in Figures 1 and 2, is clamped between two carbon blocks 5. The blocks 5 are pressed by respective clamps 6 against two parallel naturally flat surfaces of the cubic LaB6 crystal.

It is evident that mounting possibilities other than as shown in the drawings exist for crystals emitting from a single edge. For example, mounting procedures known for point electron sources can readily be adapted for the purposes of the present invention.

Two possible applications of the invention to electron beam technology with round electron sources, where physical limits of development on existing lines have been reached, are as follows:

### 1. Electron beam lithography.

E-beam writing of a mask for X-ray lithography with minimum feature sizes of 0.2 um requires writing times of approximately 80 hours on a 7.5 cm wafer. In this case throughput is limited by the serial writing process using a circular electron source, even with a variable cross-section beam shape system. This limitation can be overcome by the use of a line electron source in accordance with the invention and a parallel writing process.

### 2. Electron beam testing.

Electron beam testing of VLSI circuits is limited in spatial resolution, time resolution, and voltage resolution when a circular electron source is used, even when a variable cross-section beam shape system is used. A line source in accordance with the invention enables much higher signal/noise ratios to be otained by adapting the electron image of the line source to the size of an elongated electrode in the circuit, whose voltage is to be measured. In this way a considerable improvement in time resolution and voltage resolution can be obtained.

## Claims

1. An electron emitter comprising a lanthanum hexaboride (LaB6) single crystal mounted on to a heatable support in such a manner that one of the grown crystal edges forms an electron emitting line source and plane ends of the crystal, substantially perpendicular to the direction of the edge, define the opposite ends of the line.

2. An electron emitter as claimed in claim 1, wherein the ratio of the length of the emitting edge to its radius of curvature is at least 50 : 1.

3. An electron emitter as claimed in claim 1, wherein the ratio of the length of the emitting edge to its radius of curvature is at least 500 : 1.

4. An electron emitter as claimed in claim 1, wherein the length of the emitting edge to its width is greater than 50:1.

5. An electron emitter as claimed in claim 1, wherein the line source comprises part of an electron accelerator assembly which includes an accelerating electrode remote from the line source and a control electrode assembly located between the source and the accelerating electrode.

6. An electron emitter as claimed in claim 1, wherein the length of the grown edge and therefore the line source between the two plane ends of the crystal is at least 1mm.

7. An electron emitter as claimed in claim 1, wherein electrodes connected to a suitable source of potential are located on opposite sides of the line source to control the side emission of the two faces on opposite sides of the emitting edge.

8. An electron emitter as claimed in claim 1 wherein the emitting edge is formed between two - (1,0,0) faces of the LaB6 single crystal.

9. A method of constructing a line source electron emitter comprising the steps of mounting a single crystal on a heatable mount so that one of the naturally occurring edges of the crystal formed during growth of the crystal constitutes a ridge from which electrons can be emitted, when heated, the ridge being bounded on opposite sides by two naturally grown faces of the crystal and the ends of the ridge being defined by plane ends of the crystal which are substantially perpendicular to the direction of the ridge.

10. An electron emitter substantially as hereinbefore described with reference to the accompanying drawings.

Fig.1

Fig.2

Fig.3